# EUROPEAN PATENT SPECIFICATION

(11) **EP 4 102 369 B1**
(45) Date of publication and mention of the grant of the patent: **04.10.2023**
(21) Application number: 22172311.7
(22) Date of filing: 09.05.2022
(51) Int. Cl.: G06F 11/07, G06F 11/14

(54) **SELF-HEALING SOLID STATE DRIVES (SSDS)**
SELBSTHEILENDE SOLID STATE DRIVES (SSDS)
LECTEURS À ÉTAT SOLIDE AUTO-RÉPARATEURS (SSDS)

(30) Priority: 11.06.2021 US 202163209928 P; 22.11.2021 US 202117532844
(43) Date of publication of application: 14.12.2022
(73) Proprietor: Samsung Electronics Co., Ltd., Gyeonggi-do, 16677 (KR)
(72) Inventor: VENKATARAMAN, Gayathiri, San Jose, CA, 95134 (US); MARAM, Vishwanath, San Jose, CA, 95134 (US); PINTO, Oscar P., San Jose, CA, 95134 (US)
(74) Representative: Kuhnen & Wacker Patent- und Rechtsanwaltsbüro PartG mbB

(56) References cited:
- US-A1- 2011 219 271
- US-A1- 2019 087 274
- US-A1- 2019 146 861
- US-A1- 2021 149 757

## Description

### FIELD

The disclosure relates generally to storage devices, and more particularly to storage devices that may self-heal.

### BACKGROUND

Although storage devices tend to have a high degree of reliability, they may nevertheless make errors in storage. Thus, it may be expected that eventually, at some point during the life expectancy of a storage device, an error will occur. This error may be a read error (*i.e.,* an error that occurred when trying to read data), a write error (i.e., an error that occurred when trying to write data), or an error in the storage device controller (i.e., some unexpected condition occurred within the storage device controller), among other possibilities.

A need remains to for a storage device to self-heal.

US 2011/0219271 A1 discloses: A computer system functions to dynamically assign the storage capacity to the host computer. If an event such as a failure occurs in the logical resources, the performance requirements of the virtual volumes must be guaranteed to the host computer. Accordingly, the computer system comprising a storage apparatus, wherein the storage apparatus detects the occurrence of an event in the logical resources, compares the performance of the logical resources where the event occurred with the performance of the virtual volumes and, in accordance with the result of the comparison, sets the correspondence relationship of the virtual volumes to the logical resources.

US 2019/0087274 A1 relates to recovering storage devices in-field without the need to return the storage device to the factory. The storage device tracks detailed failure information. After receiving a signal or sequence of commands from a host device to prepare the storage device for a recovery download, the storage device determines whether to enter an adaptive field recovery state or a host-selected recovery state. If the storage device enters the adaptive field recovery state, the storage device determines which error state the device is in based on the detailed failure information, and selects an appropriate recovery level. After selecting the appropriate recovery level while in the adaptive field recovery state or after entering the host-selected recovery state, the storage device receives and downloads a recovery download package. The recovery download package comprises one or more recovery actions necessary to repair the error state.

US 2019/0146861 A1 discloses: Systems and methods for remediating errors in distributed computing. A system may include a remediation node. The remediation node may forecast receipt of a service request by a service authority. The service request may be configured to cause the service authority to modify a service assigned to an account. The service authority may be in communication with a plurality of source systems. The remediation node may acquire, from at least one of the source systems, a service parameter in which the service authority is configured to access to process the service request. The remediation node may determine an error condition corresponding to the service parameter. The remediation node may communicate, in response to determination of error condition, a remediation instruction to the at least one of the source systems, the remediation instruction configured to cause the at least one of the source systems to modify the service parameter.

US 2021/0149757 A1 relates to systems, methods, and computer readable media for identifying and responding to a panic condition on a storage system on a computing node. For example, systems may include establishing recovery instructions between a host system and a storage system in responding to a future instance of a panic condition. The storage system may provide an indication of a self-detected panic condition in a variety of ways. In response to identifying the panic condition, the host system may perform one or more recovery actions in accordance with recovery instructions accessible to the host system. This may include performing resets of specific components and reinitializing communication between the host system and storage system in less invasive ways than slower and more expensive conventional approaches for responding to panic conditions on computing nodes.

### SUMMARY

The invention is defined by the appended independent claims. Preferred embodiments of the invention are defined in the appended dependent claims.

Embodiments of the disclosure include the ability to route commands to a computational storage unit. When a command is received, a command router may determine whether the command is a command to be handled by a storage device or by the computational storage unit. The command may then be directed to either the storage device or the computational storage unit.

### BRIEF DESCRIPTION OF THE DRAWINGS

The drawings described below are examples of how embodiments of the disclosure may be implemented, and are not intended to limit embodiments of the disclosure. Individual embodiments of the disclosure may include elements not shown in particular figures and/or may omit elements shown in particular figures. The drawings are intended to provide illustration and may not be to scale.
FIG. 1 shows a system including a computational storage unit that supports maintenance on a storage device, according to embodiments of the disclosure.
FIG. 2 shows details of the machine of FIG. 1, according to embodiments of the disclosure.
FIG. 3A shows a first example arrangement of a computational storage unit that may be associated with the storage device of FIG. 1, according to embodiments of the disclosure.
FIG. 3B shows a second example arrangement of a computational storage unit that may be associated with the storage device of FIG. 1, according to embodiments of the disclosure.
FIG. 3C shows a third example arrangement of a computational storage unit that may be associated with the storage device of FIG. 1, according to embodiments of the disclosure.
FIG. 3D shows a fourth example arrangement of a computational storage unit that may be associated with the storage device of FIG. 1, according to embodiments of the disclosure.
FIG. 4 shows a Solid State Drive (SSD) supporting handling events using the computational storage unit of FIG. 1, according to embodiments of the disclosure.
FIG. 5 shows the event table of FIG. 4, according to embodiments of the disclosure.
FIG. 6 shows a sequence of operations performed by the machine of FIG. 1, the storage device of FIG. 1, and the computational storage unit of FIG. 1, according to embodiments of the disclosure.
FIG. 7 shows another view of the sequence of operations performed by the machine of FIG. 1, the storage device of FIG. 1, and the computational storage unit of FIG. 1, according to embodiments of the disclosure.
FIG. 8 shows a flowchart of an example procedure for the storage device of FIG. 1 to perform self-maintenance, according to embodiments of the disclosure.
FIG. 9 shows an alternative flowchart of an example procedure for the storage device of FIG. 1 to perform self-maintenance, according to embodiments of the disclosure.
FIG. 10 shows a flowchart of an example procedure for the event framework of FIG. 4 to receive an event, according to embodiments of the disclosure.
FIG. 11 shows a flowchart of an example procedure for the machine of FIG. 1 to download a maintenance program, according to embodiments of the disclosure.
FIG. 12 shows a flowchart of an example procedure for the event framework of FIG. 4 to execute a maintenance program, according to embodiments of the disclosure.

### DETAILED DESCRIPTION

Reference will now be made in detail to embodiments of the disclosure, examples of which are illustrated in the accompanying drawings. In the following detailed description, numerous specific details are set forth to enable a thorough understanding of the disclosure. It should be understood, however, that persons having ordinary skill in the art may practice the disclosure without these specific details. In other instances, well-known methods, procedures, components, circuits, and networks have not been described in detail so as not to unnecessarily obscure aspects of the embodiments.

It will be understood that, although the terms first, second, etc. may be used herein to describe various elements, these elements should not be limited by these terms. These terms are only used to distinguish one element from another. For example, a first module could be termed a second module, and, similarly, a second module could be termed a first module, without departing from the scope of the disclosure.

The terminology used in the description of the disclosure herein is for the purpose of describing particular embodiments only and is not intended to be limiting of the disclosure. As used in the description of the disclosure and the appended claims, the singular forms "a", "an", and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. The components and features of the drawings are not necessarily drawn to scale.

Storage device maintenance is a process that may generally be reactive. When the storage device experiences a problem, the storage device notifies the host of the problem, for example, through asynchronous event notification (AEN). The host may then determine one or more actions to take to at least partially resolve the problem. Such actions may include applying error correction using data that might not be available to the storage device, disabling particular locations within the storage device that may experience errors so that they are not used in the future, changing the configuration of the storage device so that the storage device might be able to correct errors in the future, or removing the device from service.

When an error occurs, the storage device may notify a host machine of the error. The host machine may then decide what remediation operations to take. This remediation may involve attempting to compensate for the error at the host level (for example, applying an external error correction algorithm that may use data available to the host machine that might not be available to the storage device), adjusting a configuration of the storage device (for example, changing how the storage device applies an internal error correction algorithm) in an attempt to prevent future errors, or migrating data from the storage device to another storage device (for example, if the storage device appears to be on the verge of failing), among other possibilities.

Having the host machine perform error correction may take time. That is, it may take some time for the host machine to receive the notification of the error and then respond to that notification. In addition, the host machine may manage multiple storage devices: dealing with the error on one storage device may reduce the available resources of the host for other processing.

Embodiments of the disclosure are generally directed to systems and methods to address these problems by using a computational storage unit that is either part of the storage device or associated with the storage device. The computational storage unit may have its own processing resources which may be used, reducing the load on the host to resolve problems with the storage device.

In some aspects of embodiments of the disclosure, the host may download and use one or more programs, which may be associated with particular events that may be triggered by the storage device. A single program may be associated with multiple events, and a single event may trigger multiple programs. The program may also be built into the storage device and/or the computational storage unit. Upon receiving an event, an event framework may determine the associated program(s) to trigger and may start the execution of the program(s). Depending on the operation of the program, it might not be necessary to notify the host that an error occurred using AEN.

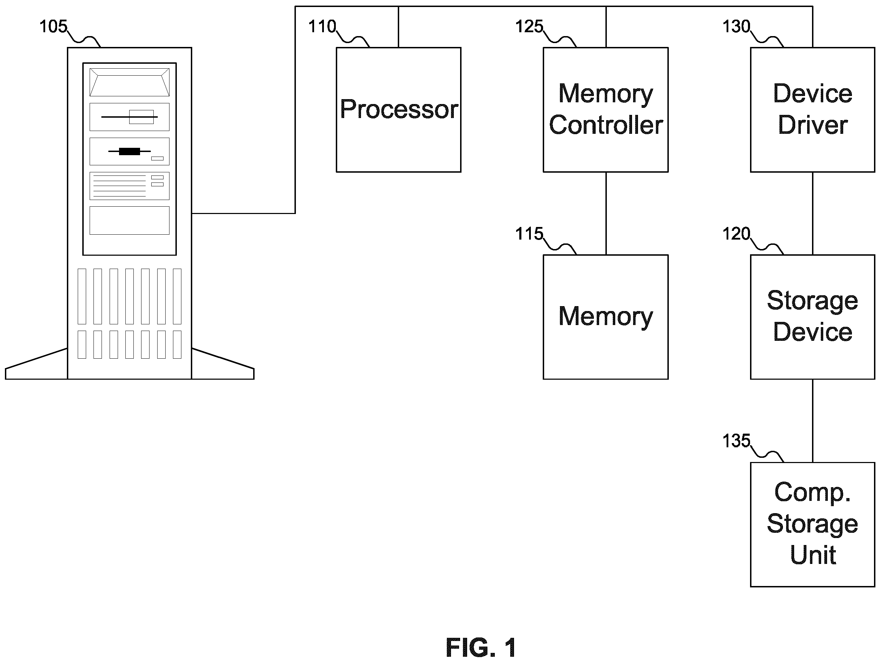

FIG. 1 shows a system including a computational storage unit that supports maintenance on a storage device, according to embodiments of the disclosure. In FIG. 1, machine 105, which may also be termed a host or a system, may include processor 110, memory 115, and storage device 120. Processor 110 may be any variety of processor. (Processor 110, along with the other components discussed below, are shown outside the machine for ease of illustration: embodiments of the disclosure may include these components within the machine.) While FIG. 1 shows a single processor 110, machine 105 may include any number of processors, each of which may be single core or multi-core processors, each of which may implement a Reduced Instruction Set Computer (RISC) architecture or a Complex Instruction Set Computer (CISC) architecture (among other possibilities), and may be mixed in any desired combination.

Processor 110 may be coupled to memory 115. Memory 115 may be any variety of memory, such as flash memory, Dynamic Random Access Memory (DRAM), Static Random Access Memory (SRAM), Persistent Random Access Memory, Ferroelectric Random Access Memory (FRAM), or Non-Volatile Random Access Memory (NVRAM), such as Magnetoresistive Random Access Memory (MRAM) etc. Memory 115 may also be any desired combination of different memory types, and may be managed by memory controller 125. Memory 115 may be used to store data that may be termed "short-term": that is, data not expected to be stored for extended periods of time. Examples of short-term data may include temporary files, data being used locally by applications (which may have been copied from other storage locations), and the like.

Processor 110 and memory 115 may also support an operating system under which various applications may be running. These applications may issue requests (which may also be termed commands) to read data from or write data to either memory 115 or storage device 120. Storage device 120 may be accessed using device driver 130.

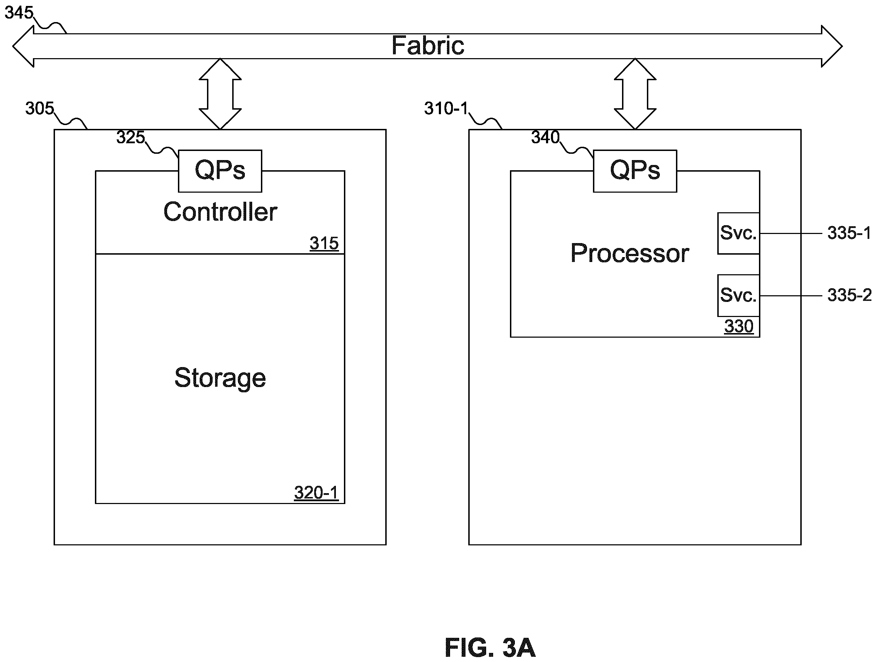

Storage device 120 may be associated with computational storage unit 135. As discussed below with reference to FIGs. 3A-3D, computational storage unit 135 may be part of storage device 120, or it may be separate from storage device 120. The phrase "associated with" is intended to cover both a storage device that includes a computational storage unit and a storage device that is paired with a computational storage unit that is not part of the storage device itself. In other words, a storage device and a computational storage unit may be said to be "paired" when they are physically separate devices but are connected in a manner that enables them to communicate with each other.

In addition, the connection between storage device 120 and paired computational storage unit 135 might enable the two devices to communicate, but might not enable one (or both) devices to work with a different partner: that is, storage device 120 might not be able to communicate with another computational storage unit, and/or computational storage unit 135 might not be able to communicate with another storage device. For example, storage device 120 and paired computational storage unit 135 might be connected serially (in either order) to a fabric such as a bus, enabling computational storage unit 135 to access information from storage device 120 in a manner another computational storage unit might not be able to achieve.

Processor 110 and storage device 120 may be connected to a fabric. The fabric may be any fabric along which information may be passed. The fabric may include fabrics that may be internal to machine 105, and which may use interfaces such as Peripheral Component Interconnect Express (PCIe), Serial AT Attachment (SATA), Small Computer Systems Interface (SCSI), among others. The fabric may also include fabrics that may be external to machine 105, and which may use interfaces such as Ethernet, InfiniBand, or Fibre Channel, among others. In addition, the fabric may support one or more protocols, such as Non-Volatile Memory (NVM) Express (NVMe), NVMe over Fabrics (NVMe-oF), or Simple Service Discovery Protocol (SSDP), among others. Thus, the fabric may be thought of as encompassing both internal and external networking connections, over which commands may be sent, either directly or indirectly, to storage device 120 (and more particularly, the computational storage unit associated with storage device 120).

While FIG. 1 shows one storage device 120 and one computational storage unit 135, there may be any number (one or more) of storage devices, and/or any number (one or more) of computational storage units in machine 105.

While FIG. 1 uses the generic term "storage device", embodiments of the disclosure may include any storage device formats that may benefit from the use of computational storage units, examples of which may include hard disk drives and Solid State Drives (SSDs). Any reference to "SSD" below should be understood to include such other embodiments of the disclosure. In addition, while the discussion above (and below) focuses on storage device 120 as being associated with a computational storage unit, embodiments of the disclosure may extend to devices other than storage devices that may include or be associated with a computational storage unit. Any reference to "storage device" above (and below) may be understood as also encompassing other devices that might be associated with a computational storage unit.

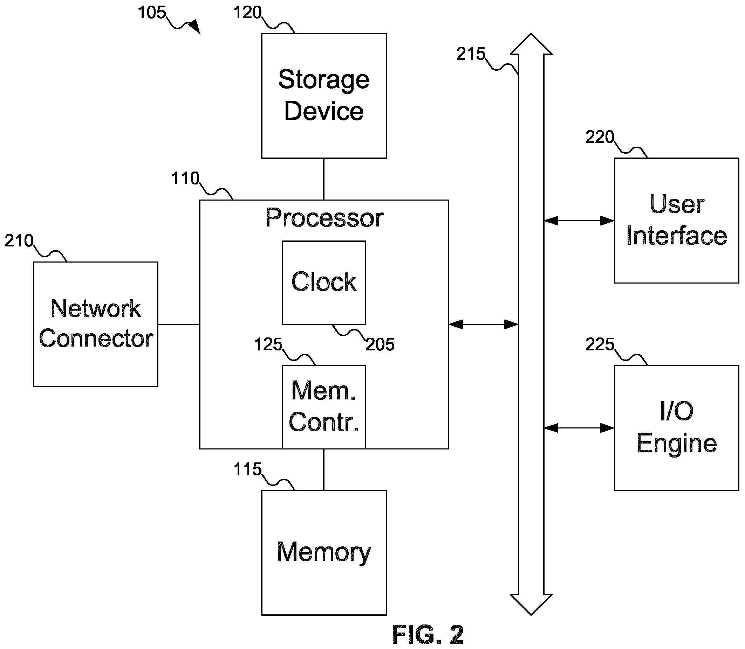

FIG. 2 shows details of machine 105 of FIG. 1, according to embodiments of the disclosure. In FIG. 2, typically, machine 105 includes one or more processors 110, which may include memory controllers 125 and clocks 205, which may be used to coordinate the operations of the components of the machine. Processors 110 may also be coupled to memories 115, which may include random access memory (RAM), read-only memory (ROM), or other state preserving media, as examples. Processors 110 may also be coupled to storage devices 120, and to network connector 210, which may be, for example, an Ethernet connector or a wireless connector. Processors 110 may also be connected to buses 215, to which may be attached user interfaces 220 and Input/Output (I/O) interface ports that may be managed using I/O engines 225, among other components.

FIGs. 3A-3D show various arrangements of computational storage unit 135 of FIG. 1 (which may also be termed a "computational device" or "device") that may be associated with storage device 120 of FIG. 1, according to embodiments of the disclosure. In FIG. 3A, storage device 305 and computational device 310-1 are shown. Storage device 305 may include controller 315 and storage 320-1, and may be reachable across queue pairs: queue pairs 325 may be used both for management of storage device 305 and to control I/O of storage device 305.

Computational device 310-1 may be paired with storage device 305. Computational device 310-1 may include any number (one or more) processors 330, which may offer one or more services 335-1 and 335-2. To be clearer, each processor 330 may offer any number (one or more) services 335-1 and 335-2 (although embodiments of the disclosure may include computational device 310-1 including exactly two services 335-1 and 335-2). Each processor 330 may be a single core processor or a multi-core processor. Computational device 310-1 may be reachable across queue pairs 340, which may be used for both management of computational device 310-1 and/or to control I/O of computational device 310-1

Processor(s) 330 may be thought of as near-storage processing: that is, processing that is closer to storage device 305 than processor 110 of FIG. 1. Because processor(s) 330 are closer to storage device 305, processor(s) 330 may be able to execute commands on data stored in storage device 305 more quickly than for processor 110 of FIG. 1 to execute such commands. While not shown in FIG. 3A, processor(s) 330 may have associated memory which may be used for local execution of commands on data stored in storage device 305. This associated memory may include local memory similar to memory 115 of FIG. 1, on-chip memory (which may be faster than memory such as memory 115, but perhaps more expensive to produce), or both.

While FIG. 3A shows storage device 305 and computational device 310-1 as being separately reachable across fabric 345, embodiments of the disclosure may also include storage device 305 and computational device 310-1 being serially connected (as shown in FIG. 1). That is, commands directed to storage device 305 and computational device 310-1 might both be received at the same physical connection to fabric 345 and may pass through one device to reach the other. For example, if computational device 310-1 is located between storage device 305 and fabric 345, computational device 310-1 may receive commands directed to both computational device 310-1 and storage device 305: computational device 310-1 may process commands directed to computational device 310-1, and may pass commands directed to storage device 305 to storage device 305. Similarly, if storage device 305 is located between computational device 310-1 and fabric 345, storage device 305 may receive commands directed to both storage device 305 and computational device 310-1: storage device 305 may process commands directed to storage device 305 and may pass commands directed to computational device 310-1 to computational device 310-1.

Services 335-1 and 335-2 may offer a number of different functions that may be executed on data stored in storage device 305. For example, services 335-1 and 335-2 may offer predefined functions, such as encryption, decryption, compression, and/or decompression of data, erasure coding, and/or applying regular expressions. Or, services 335-1 and 335-2 may offer more general functions, such as data searching and/or SQL functions. Services 335-1 and 335-2 may also support running application-specific code. That is, the application using services 335-1 and 335-2 may provide custom code to be executed using data on storage device 305. Services 335-1 and 335-2 may also any combination of such functions. Table 1 lists some examples of services that may be offered by processor(s) 330.

**Table 1: Service Types**

| |
|---|
| Compression |
| Encryption |
| Database filter |
| Erasure coding |
| RAID |
| Hash/CRC |
| RegEx (pattern matching) |
| Scatter Gather |
| Pipeline |
| Video compression |
| Data deduplication |
| Operating System Image Loader |
| Container Image Loader |
| Berkeley packet filter (BPF) loader |
| FPGA Bitstream loader |
| Large Data Set |

Processor(s) 330 (and, indeed, computational device 310-1) may be implemented in any desired manner. Example implementations may include a local processor, such as Central Processing Unit (CPU) or some other processor, a Graphics Processing Unit (GPU), a General Purpose GPU (GPGPU), a Data Processing Unit (DPU), a Tensor Processing Unit (TPU), or a Neural Processing Unit (NPU), among other possibilities. Processor(s) 330 may also be implemented using a Field Programmable Gate Array (FPGA) or an Application-Specific Integrated Circuit (ASIC), among other possibilities. If computational device 310-1 includes more than one processor 330, each processor may be implemented as described above. For example, computational device 310-1 might have one each of CPU, TPU, and FPGA, or computational device 310-1 might have two FPGAs, or computational device 310-1 might have two CPUs and one ASIC, etc.

Depending on the desired interpretation, either computational device 310-1 or processor(s) 330 may be thought of as a computational storage unit.

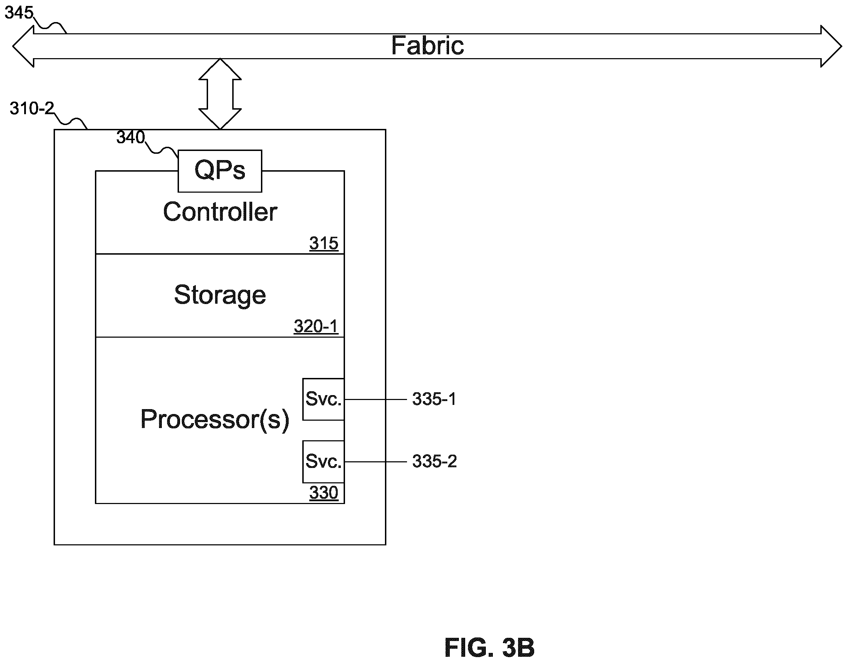

Whereas FIG. 3A shows storage device 305 and computational device 310-1 as separate devices, in FIG. 3B they may be combined. Thus, computational device 310-2 may include controller 315, storage 320-1, and processor(s) 330 offering services 335-1 and 335-2. As with storage device 305 and computational device 310-1 of FIG. 3A, management and I/O commands may be received via queue pairs 340. Even though computational device 310-2 is shown as including both storage and processor(s) 330, FIG. 3B may still be thought of as including a storage device that is associated with a computational storage unit.

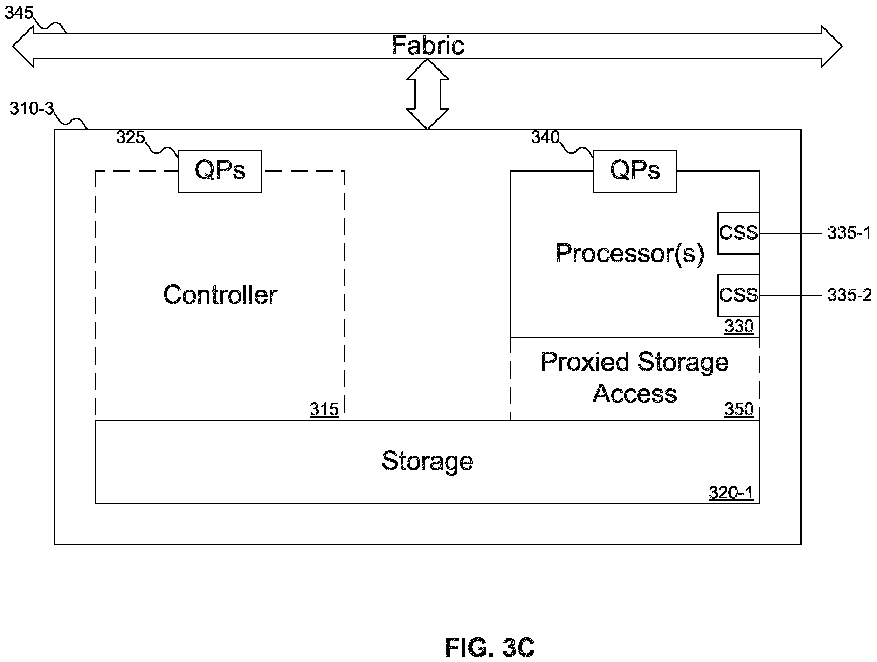

In yet another variation shown in FIG. 3C, computational device 310-3 is shown. Computational device 310-3 may include controller 315 and storage 320-1, as well as processor(s) 330 offering services 335-1 and 335-2. But even though computational device 310-3 may be thought of as a single component including controller 315, storage 320-1, and processor(s) 330 (and also being thought of as a storage device associated with a computational storage unit), unlike the implementation shown in FIG. 3B controller 315 and processor(s) 330 may each include their own queue pairs 325 and 340 (again, which may be used for management and/or I/O). By including queue pairs 325, controller 315 may offer transparent access to storage 320-1 (rather than requiring all communication to proceed through processor(s) 330).

In addition, processor(s) 330 may have proxied storage access 350 to storage 320-1. Thus, instead of routing access requests through controller 315, processor(s) 330 may be able to directly access the data from storage 320-1.

In FIG. 3C, both controller 315 and proxied storage access 350 are shown with dashed lines to represent that they are optional elements, and may be omitted depending on the implementation.

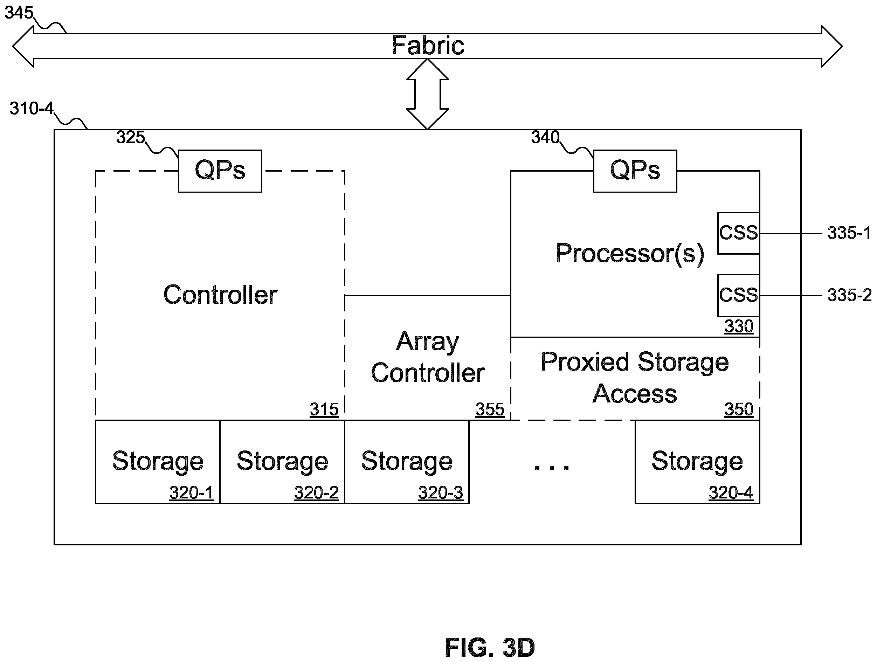

Finally, FIG. 3D shows yet another implementation. In FIG. 3D, computational device 310-4 is shown, which may include controller 315 and proxied storage access 350 similar to FIG. 3C. In addition, computational device 310-4 may include an array of one or more storage 320-1 through 320-4. While FIG. 3D shows four storage elements, embodiments of the disclosure may include any number (one or more) of storage elements. In addition, the individual storage elements may be other storage devices, such as those shown in FIGs. 3A-3D.

Because computational device 310-4 may include more than one storage element 320-1 through 320-4, computational device 310-4 may include array controller 355. Array controller 355 may manage how data is stored on and retrieved from storage elements 320-1 through 320-4. For example, if storage elements 320-1 through 320-4 are implemented as some level of a Redundant Array of Independent Disks (RAID), array controller 355 may be a RAID controller. If storage elements 320-1 through 320-4 are implemented using some form of Erasure Coding, then array controller 355 may be an Erasure Coding controller.

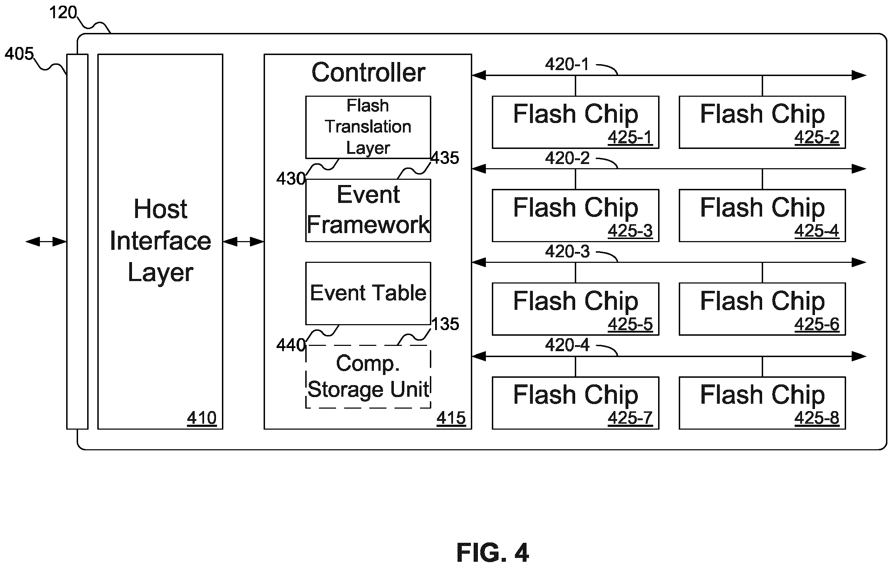

FIG. 4 shows a Solid State Drive (SSD) supporting handling events using the computational storage unit of FIG. 1, according to embodiments of the disclosure. In FIG. 4, SSD 120 may include interface 405. Interface 405 may be an interface used to connect SSD 120 to machine 105 of FIG. 1, and may receive I/O requests, such as read requests and write requests, from processor 110 of FIG. 1 (or other request sources). SSD 120 may include more than one interface 405: for example, one interface might be used for block-based read and write requests, and another interface might be used for key-value read and write requests. While FIG. 4 suggests that interface 405 is a physical connection between SSD 120 and machine 105 of FIG. 1, interface 405 may also represent protocol differences that may be used across a common physical interface. For example, SSD 120 might be connected to machine 105 using a U.2 or an M.2 connector, but may support block-based requests and key-value requests: handling the different types of requests may be performed by a different interface 405.

SSD 120 may also include host interface layer 410, which may manage interface 405. If SSD 120 includes more than one interface 405, a single host interface layer 410 may manage all interfaces, SSD 120 may include a host interface layer for each interface, or some combination thereof may be used.

SSD 120 may also include SSD controller 415, various channels 420-1, 420-2, 420-3, and 420-4, along which various flash memory chips 425-1, 425-2, 425-3, 425-4, 425-5, 425-6, 425-7, and 425-8 may be arrayed (flash memory chips 425-1 through 425-8 may be referred to collectively as flash memory chips 425). SSD controller 415 may manage sending read requests and write requests to flash memory chips 425-1 through 425-8 along channels 420-1 through 420-4 (which may be referred to collectively as channels 420). Although FIG. 4 shows four channels and eight flash memory chips, embodiments of the disclosure may include any number (one or more, without bound) of channels including any number (one or more, without bound) of flash memory chips.

Within each flash memory chip, the space may be organized into blocks, which may be further subdivided into pages, and which may be grouped into superblocks. Page sizes may vary as desired: for example, a page may be 4 KB of data. If less than a full page is to be written, the excess space is "unused". Blocks may contain any number of pages: for example, 140 or 230. And superblocks may contain any number of blocks. A flash memory chip might not organize data into superblocks, but only blocks and pages.

While pages may be written and read, SSDs typically do not permit data to be overwritten: that is, existing data may be not be replaced "in place" with new data. Instead, when data is to be updated, the new data is written to a new page on the SSD, and the original page is invalidated (marked ready for erasure). Thus, SSD pages typically have one of three states: free (ready to be written), valid (containing valid data), and invalid (no longer containing valid data, but not usable until erased) (the exact names for these states may vary).

But while pages may be written and read individually, the block is the basic unit of data that may be erased. That is, pages are not erased individually: all the pages in a block are typically erased at the same time. For example, if a block contains 230 pages, then all 230 pages in a block are erased at the same time. This arrangement may lead to some management issues for the SSD: if a block is selected for erasure that still contains some valid data, that valid data may need to be copied to a free page elsewhere on the SSD before the block may be erased. (In some embodiments of the disclosure, the unit of erasure may differ from the block: for example, it may be a superblock, which as discussed above may be a set of multiple blocks.)

Because the units at which data is written and data is erased differ (page vs. block), if the SSD waited until a block contained only invalid data before erasing the block, the SSD might run out of available storage space, even though the amount of valid data might be less than the advertised capacity of the SSD. To avoid such a situation, SSD controller 415 may include a garbage collection controller (not shown in FIG. 4). The function of the garbage collection may be to identify blocks that contain all or mostly all invalid pages and free up those blocks so that valid data may be written into them again. But if the block selected for garbage collection includes valid data, that valid data will be erased by the garbage collection logic (since the unit of erasure is the block, not the page). To avoid such data being lost, the garbage collection logic may program the valid data from such blocks into other blocks. Once the data has been programmed into a new block (and the table mapping logical block addresses (LBAs) to physical block addresses (PBAs) updated to reflect the new location of the data), the block may then be erased, returning the state of the pages in the block to a free state.

SSDs also have a finite number of times each cell may be written before cells may not be trusted to retain the data correctly. This number is usually measured as a count of the number of program/erase cycles the cells undergo. Typically, the number of program/erase cycles that a cell may support mean that the SSD will remain reliably functional for a reasonable period of time: for personal users, the user may be more likely to replace the SSD due to insufficient storage capacity than because the number of program/erase cycles has been exceeded. But in enterprise environments, where data may be written and erased more frequently, the risk of cells exceeding their program/erase cycle count may be more significant.

To help offset this risk, SSD controller 415 may employ a wear leveling controller (not shown in FIG. 4). Wear leveling may involve selecting data blocks to program data based on the blocks' program/erase cycle counts. By selecting blocks with a lower program/erase cycle count to program new data, the SSD may be able to avoid increasing the program/erase cycle count for some blocks beyond their point of reliable operation. By keeping the wear level of each block as close as possible, the SSD may remain reliable for a longer period of time.

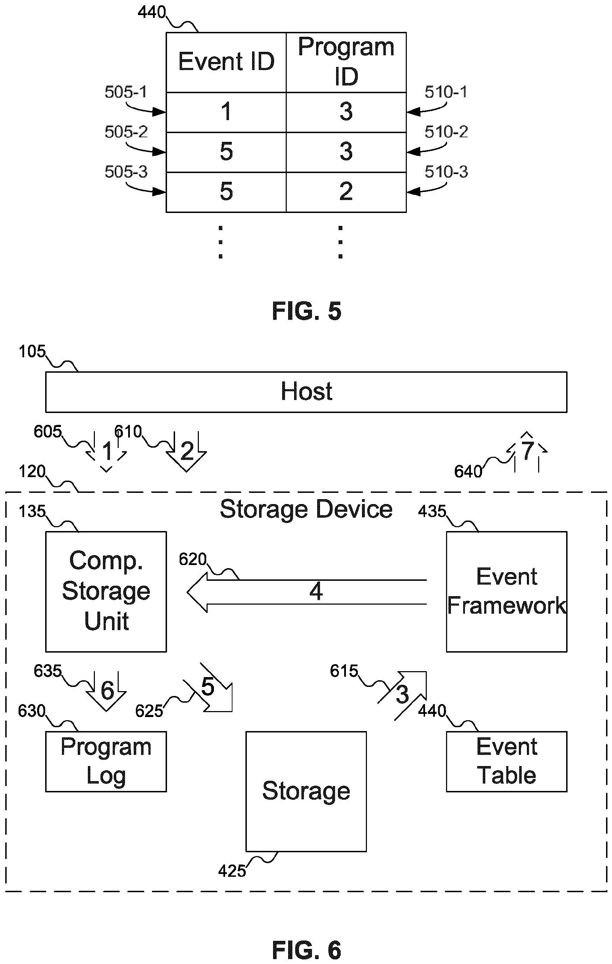

SSD controller 415 may include flash translation layer (FTL) 430 (which may be termed more generally a translation layer, for storage devices that do not use flash storage), event framework 435, and event table 440. FTL 430 may handle translation of LBAs or other logical IDs (as used by processor 110 of FIG. 1) and physical block addresses (PBAs) or other physical addresses where data is stored in flash chips 425-1 through 425-8. FTL 430, may also be responsible for relocating data from one PBA to another, as may occur when performing garbage collection and/or wear leveling. Event framework 435 may manage events that occur within SSD 120 (or computational storage unit 135, as discussed further with reference to FIGs. 6-7 below) to execute programs using computational storage unit 135 to resolve such events. Event framework 435 may include some form of processor, such as an FPGA, an ASIC, a CPU, a GPU, a GPGPU, a DPU, a TPU, or an NPU, among other possibilities. Event table 440 may store associations between events and programs to be executed when such errors are triggered. Event table 440 may be stored in some form of storage (which may be a volatile storage or a non-volatile storage) within SSD controller 415 (or somewhere else within storage device 120). Event table 440 is discussed further with reference to FIG. 5 below.

FIG. 4 also shows SSD 120 as including computational storage unit 135. As discussed above, in some embodiments of the disclosure SSD 120 may include computational storage unit 135; in other embodiments of the disclosure, computational storage unit 135 may be paired with SSD 120, but physically separate from SSD 120. Thus, FIG. 4 shows computational storage unit 135 with dashed lines, to show that computational storage unit 135 might or might not be within SSD 120.

FIG. 5 shows event table 440 of FIG. 4, according to embodiments of the disclosure. In FIG. 5, event table 440 is shown as including event IDs 505-1, 505-2, and 505-3 (which may be referred to collectively as event IDs 505). Event IDs 505 may identify events that may occur in storage device 120 of FIG. 1. For example, there may be event IDs for error events, for health status events, for notice events, for command set-specific events, and for vender-defined events. Event IDs 505 may be unique to individual events, or may represent classes of such events. For example, event ID 1 might represent a read error in storage device 120 of FIG. 1, and event ID 5 might represent that a command could not be processed correctly due to problems with the parameters provided with the command. Or, event ID 1 might represent the class of errors that might occur within storage device 120 of FIG. 1 (such as read errors, write errors, error correction code errors, etc.) and event ID 5 might represent the class of events associated with problems processing a command.

Each event ID may be associated with a particular program ID: event ID 505-1 is shown as associated with program ID 510-1, event ID 505-2 is shown as associated with program ID 510-2, and event ID 505-3 is shown as associated with program ID 510-3 (program IDs 510-1, 510-2, and 510-3 may be referred to collectively as program IDs 510). Note that program IDs 510 may be merely identifiers of programs, whose locations may be stored elsewhere (and whose locations may be determined using program IDs 510: perhaps by another table that maps program IDs to addresses in a memory where the program is stored), or program IDs 510 may be pointers to where the programs are stored in a memory, or program IDs 510 may be a copy of the code to be executed when the associated event ID 505 is received, among other possibilities: all such possibilities are intended to be covered by event table 440. While event table 440 shows three such pairings of event ID and program ID, embodiments of the disclosure may include any number (one or more) of such associations. (Technically, zero such associations are possible as well, but in that case event framework 435 would not be able to trigger a program to perform any remediation on storage device 120 of FIG. 1.)

When event framework 435 of FIG. 4 receives notice that a particular event has occurred (based on the event ID), event framework 435 of FIG. 4 may access event table 440 and determine which program to execute. Event framework 435 then causes the associated program to be executed by computational storage unit 135 of FIG. 1.

Event table 440 shows two interesting situations that are worth noting. First, note that event IDs 505-1 and 505-2 are both associated with program ID 3. This situation shows that a single program may be able to perform remediation for multiple different events that may occur in storage device 120 of FIG. 1. Whether this situation may occur may depend on the implementation of the remediation program: if a program is not designed to handle a particular event ID, then the program should not be associated with that event ID in event table 440.

Second, note that event IDs 505-2 and 505-3 are the same, but are associated with different program IDs 510-2 and 510-3. This situation shows that a single event ID may trigger multiple different programs. Whether those programs are executed in parallel or sequentially may depend on whether computational storage unit 135 of FIG. 1 supports parallel execution of programs. In addition, in some embodiments of the disclosure, a single event ID may be associated with only one program: in such embodiments of the disclosure, that program may, in turn, trigger other programs as part of its execution, enabling the use of multiple programs for a single event without event table 440 associating multiple programs with a single event.

The programs identified by program IDs 510 may be any desired type of program. For example, the programs may be diagnostic programs, collecting information about an event. Or, the programs may be reactive programs, designed to try and resolve the issues identified by the events. Examples of reactive programs may include programs to attempt to recover data (such as may occur if data is spread across multiple storage devices with redundancy, such as may occur with data in levels 1, 4, 5, and 6 of a Redundant Array of Independent Disks (RAID) array), failover programs (which may change where data is stored to avoid a storage device that is beginning to fail), and deduplications programs (which may use data deduplication to free up space on the storage device). Events may also occur due to operations within computational storage unit 135: for example, due to an error within a memory of computational storage unit 135. Or, the programs may be artificial intelligence (AI)/machine learning programs, designed to try and predict future failures of the storage device based on events that have occurred to date. Different types of programs may be used in response to different events: embodiments of the disclosure may include as many programs as desired, which may be of the same or different types.

The programs identified by program IDs 510 may be of any desired format. For example, the programs may be extended Berkeley packet filter (eBPF) Executable and Linkable Format (ELF) programs, FPGA bitstreams, programs that are executable under an operating system supported by computational storage unit 135, and so on. In short, the programs may be any code that may be executed by computational storage unit 135.

The programs may also update any relevant information in storage device 120 and/or computational storage unit 135. For example, the programs may update a program log with information about the operation of the program. But the programs may also clear any events after the programs have handled the event. In this manner, the occurrence and remediation of an event may be performed transparently to machine 105 of FIG. 1.

The programs identified by program IDs 510 may use state information to determine whether to execute or not. For example, a program might be executed only the first time the event occurs, with any subsequent events not triggering the program. This may be accomplished, as said above, but storing state information in computational storage unit 135. The program may access the state information to determine if the program has been executed before. If the program has not been executed before, the program may execute and set the state information accordingly; if the program has been executed before, then the program might not execute. Another way in which a program might limit its own future execution would be to disable its own execution, using a command similar to one that may disable AEN, or to update event table 440 to remove the association between the event ID and the program ID.

As another example of the use of state information, a program may count the number of times the program has been executed. The program may then compare that number with a threshold and may use that information to manage what the program does. For example, a program that recovers from failures to read data may track the number of read errors that occur within storage device 120 of FIG. 1 offline. If that number satisfies a threshold, the program may elect to take storage device 120 of FIG. 1 offline rather than attempt to resolve the individual read error that triggered that execution of the program.

The programs may also interact with other devices within machine 105 of FIG. 1. For example, as noted above, a failover program may change where data is stored. This may include moving data off storage device 120 of FIG. 1 onto another storage device. For such a failover program to operate successfully, the failover program may need to send data to the other storage device, and may need to update one or more applications running on processor 110 of FIG. 1 regarding the new storage device storing the data.

In some embodiments of the disclosure, storage device 120 of FIG. 1 may be part of a storage array (for example, within a RAID array). In such embodiments of the disclosure, the occurrence of an event at storage device 120 of FIG. 1 may trigger a program being executed on another storage device, or on a computational storage unit associated with another storage device. For example, consider a RAID array that includes four storage devices in a RAID 1+0 (sometimes called RAID 10) configuration (a stripe of mirrors). Within each mirror group, one device may be designated as the primary storage device for a read operation. If the primary storage device in a mirror pair fails, a program may inform another storage device in the mirror group to become the primary storage device.

This concept may be generalized further: an event that occurs in one storage device might be handled by another storage device (or computational storage unit associated with another storage device). For example, consider the situation where computational storage unit 135 of FIG. 1 issues a notification that computational storage unit 135 has failed to the point of being unable to perform any computations (which could happen if, for instance, there is a short circuit within computational storage unit 135). Computational storage unit 135 then might not be able to perform any remediation for an event that occurs in storage 425. While ultimately it may be necessary to replace computational storage unit 135 with a new computational storage unit that is functional (or replace storage device 120 entirely, if computational storage unit 135 is built into storage device 120), until such replacement can occur, some other component may need to handle events that occur within storage device 120. Of course, storage device 120 may use AEN to notify machine 105 of events and let machine 105 perform any remediation. But if there is another computational storage unit that is available to execute the program and can access storage 425 (even if in a relatively reduced capacity as compared with computational storage unit 135), it may be possible for that other computational storage unit to execute the program and perform remediation on storage 425.

FIG. 6 shows a sequence of operations performed by machine 105 of FIG. 1, storage device 120 of FIG. 1, and computational storage unit 135 of FIG. 1, according to embodiments of the disclosure. In FIG. 6, computational storage unit 135 is shown as within storage device 120, but embodiments of the disclosure may function with computational storage unit 135 being outside storage device 120.

Machine 105 may start by downloading a program to computational storage unit 135, shown as operation 605. In some embodiments of the disclosure, the program may be pre-loaded into computational storage unit 135 by the vendor, in which case operation 605 may be omitted (shown by operation 605 using a dashed line). If a program is pre-loaded into computational storage unit 135, machine 105 may discover the program using standard discovery techniques. Machine 105 may also instruct storage device 120 to store an association between an event ID and the program in event table 440, shown as operation 610.

At some point during its operation, storage 425 (or controller 415 of FIG. 4) may notify event framework 435 that an event has occurred, shown as operation 615. This notification may occur through storage 425 sending an event to event framework 435, event framework 435 examining SMART data for storage 425, or event framework 435 examining an error table and noticing a new entry. Event framework 435 may determine the ID of the event, and may examine event table 440 to see if there is an entry including that event ID.

Upon finding an association between the event ID and a program, event framework 435 may request computational storage unit 135 execute the program, shown as operation 620. Computational storage unit 135 may then execute the program to attempt remediation of the event, as shown by operation 625. Upon completion, computational storage unit 135 may log the results of the remediation in program log 630, as shown by operation 635. Program log 630 may be part of storage device 120 or computational storge unit 135 (and therefore may be outside storage device 120, if computational storage unit 135 is outside storage device 120). Program log 630 may be used to extend the error information about a command that completed with an error. Program log 630 may also be used to report an error that is not specific to a particular command. Finally, event framework may use asynchronous event notification (AEN) to notify machine 105 of the event and its remediation, as shown by operation 640. Note that if remediation was successful, machine 105 may not need to be notified about either the event or its remediation: in such situations, operation 640 may be omitted (shown by operation 640 using a dashed line).

If no entry in event table 440 may be found with the event ID, then event framework 435 may not know what to do to address the event, and may use AEN to notify machine 105 of the event, also shown as operation 640.

In some embodiments of the disclosure, there may be an entry in event table 440, associating an event with a program, but the program might not yet be stored in computational storage unit 135. For example, there might be insufficient storage within computational storage unit 135 for the program (which may occur if other programs have been downloaded). Or the event might be considered sufficiently unlikely that it is considered more desirable to download the program if the event is triggered but not before. In such situations, upon the occurrence of the event, machine 105 may be notified to start downloading the program to computational storage unit 135 so that the program may be executed.

In some embodiments of the disclosure, machine 105 might be designed to operate in a reactive mode. That is, machine 105 might know what program is to be executed upon the occurrence of an event, but machine 105 is designed to download and execute the program after machine 105 receives notification of the event. In such embodiments of the disclosure, machine 105 may remain in control of handling the events and may identify which program is to be executed by computational storage unit 135. Machine 105 may even download the program to computational storage unit 135 in response to the occurrence of the event rather than download the program in advance. In such embodiments of the disclosure, the information in event table 440 may be effectively stored within machine 105 (although storage device 120 may still include event table 440). In some of these embodiments of the disclosure, event table 440 may still identify the program to be executed, but that program might not yet be downloaded into computational storage unit 135, and machine 105 may be notified to download the program for execution in response to the event.

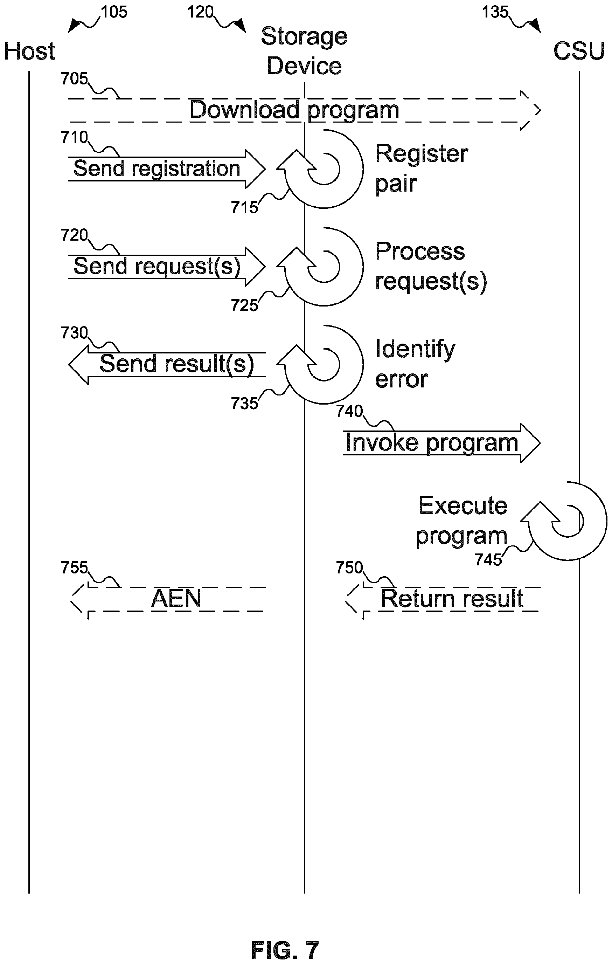

FIG. 7 shows another view of the sequence of operations performed by machine 105 of FIG. 1, storage device 120 of FIG. 1, and computational storage unit 135 of FIG. 1, according to embodiments of the disclosure. At operation 705, machine 105 may send the program to computational storage unit 135. As discussed above, computational storage unit 135 may be preloaded with the program, in which case machine 105 would not need to send the program (shown by operation 705 using dashed lines). At operation 710, machine 105 may send a registration to storage device 120 for storage in event table 440 of FIG. 4. At operation 715, storage device 120 may register the event/program pair in event table 440 of FIG. 4. Note that even if the program is preloaded onto computational storage unit 135, machine 105 may still register the use of that program upon the occurrence of a particular event (although event table 440 of FIG. 4 may be preconfigured to trigger a preloaded program based on known event IDs).

At operation 720, machine 105 may send various requests to storage device 120. These requests may include requests to read or write data from storage device 120, requests to perform maintenance on or to configure storage device 120, requests to utilize a service of computational storage unit 135, or any other request that may be issued to either storage device 120 or computational storage unit 135. At operation 725, storage device 120 (or computational storage unit 135, if the request was sent to or intended for computational storage unit 135) may process the requests. At operation 730, the results of these requests may be sent back to machine 105.

But in some instances, storage device 120 (or computational storage unit 135) may report an event, indicating something might not have proceeded as expected, or some data about the operation of storage device 120 and/or computational storage unit 135 has been generated. When such an event occurs, at operation 735 storage device 120 (more specifically, event framework 435 of FIG. 4 within storage device 120) may identify the error. Event framework 435 of FIG. 4 may then use that event ID to identify a program (or programs, if multiple programs are associated with a single event ID) that should be executed, using event table 440 of FIG. 4. At operation 740, event framework 435 of FIG. 4 may invoke the program for execution by computational storage unit 135. At operation 745, computational storage unit 135 may execute the program, and at operation 750 computational storage unit 135 may return a result of the program to storage device 120. Note that it is not required that the program return a result in operation 750, which is why operation 750 is shown with dashed lines (to show that operation 750 may be omitted).

Storage device 120 may then use the result of the program to determine whether the problem was resolved using the program. If the problem was not resolved, then storage device 135 may use AEN at operation 755 to notify machine 105 of the event. Note that storage device 120 may use AEN at operation 755 even if the program was successful in resolving the problem, and may use AEN at operation 755 to notify machine 105 if no program was associated with the event ID in event table 440 of FIG. 4. Because operation 755 might or might not be performed, depending on the facts of the situation, operation 755 is shown with dashed lines (to show that operation 755 may be omitted).

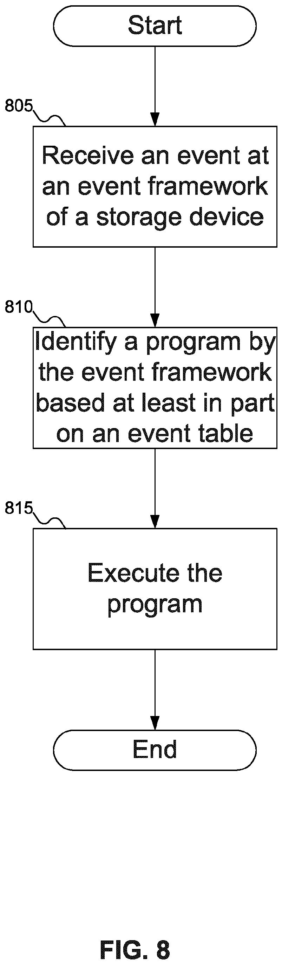

FIG. 8 shows a flowchart of an example procedure for storage device 120 of FIG. 1 to perform self-maintenance, according to embodiments of the disclosure. In FIG. 8, at block 805, event framework 435 of FIG. 4 may receive notice of an event that occurred. This event may have occurred within storage device 120 of FIG. 1 (and may originate, for example, from storage 425 of FIG. 4 or storage controller 415 of FIG. 4), or within computational storage unit 135 of FIG. 1. At block 810, event framework 435 of FIG. 4 may use event table 440 of FIG. 4 to identify a program to perform maintenance on storage device 120 of FIG. 1 or computational storage unit 135 of FIG. 1. Event framework 435 may use the event referenced in block 805 to identify an associated program within event table 440 of FIG. 4 to execute. Finally, at block 815, the program identified in block 810 is executed.

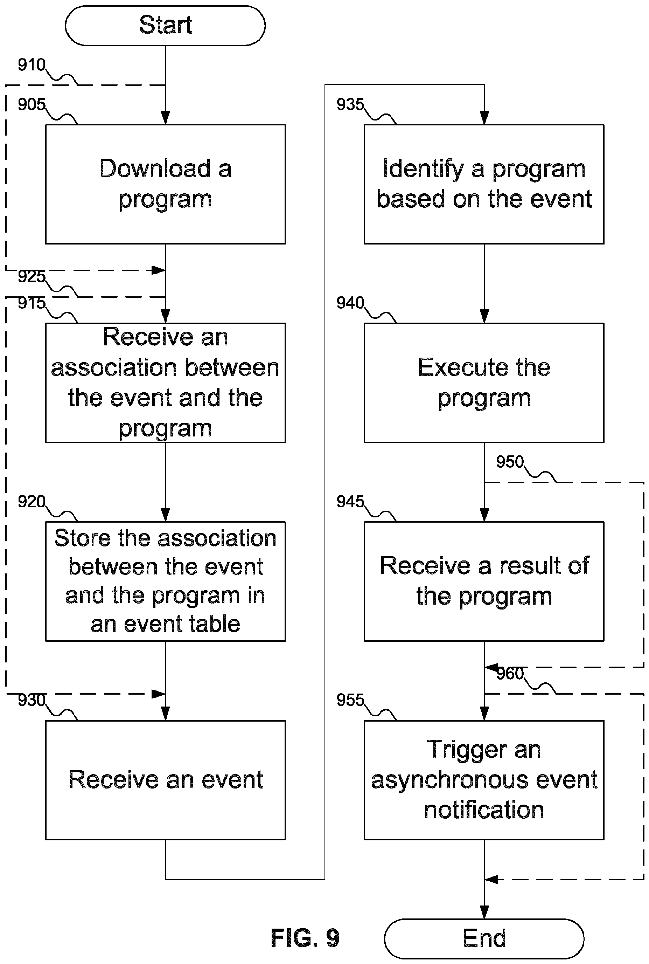

FIG. 9 shows an alternative flowchart of an example procedure for storage device 120 of FIG. 1 to perform self-maintenance, according to embodiments of the disclosure. In FIG. 9, at block 905, machine 105 of FIG. 1 may download a program to computational storage unit 135 of FIG. 1 (or into storage device 120 of FIG. 1, if storage 120 of FIG. 1 is capable of executing a program). If the program is pre-loaded onto computational storage unit 135 of FIG. 1 (or storage device 120 of FIG. 1), the block 905 may be omitted, as shown by dashed line 910.

At block 915, machine 105 of FIG. 1 may send a registration to storage device 120 of FIG. 1. This registration may associate event ID 505 of FIG. 5 with program ID 510 of FIG. 5, indicating which program machine 105 of FIG. 1 would like to be executed if the event is triggered. At block 920, storage device 120 of FIG. 1 may store event ID 505 of FIG. 5 and program ID 510 of FIG. 5 as an associated pair in event table 440 of FIG. 4. If the registration is already stored in event table 440 of FIG. 4 (as may occur, for example, if the program is pre-loaded onto computational storage unit 135 of FIG. 1 or storage device 120 of FIG. 1, then blocks 915 and 920 may be omitted, as shown by dashed line 925.

At block 930, event framework 435 of FIG. 4 may receive notice of an event (that is, event framework 435 of FIG. 4 may receive event ID 505 of FIG. 5 from storage 425 of FIG. 4 or computational storage unit 135 of FIG. 1). At block 935, event framework 435 of FIG. 4 may use event table 440 of FIG. 4 to identify program ID 510 of FIG. 5 based on event ID 505. At block 940, event framework 435 of FIG. 4 may have computational storage unit 135 of FIG. 1 execute the program.

At block 945, event framework 435 of FIG. 4 may receive a result of the program from computational storage unit 135 of FIG. 1. Note that computational storage unit 135 of FIG. 1 might only send a result if the program was not able to perform remediation as expected: therefore, in some embodiments of the disclosure computational storage unit 135 might not always send a result of the program to event framework 435 of FIG. 4. In such situations, block 945 may be omitted, as shown by dashed arrow 950.

Finally, at block 955, event framework 435 of FIG. 4 may use AEN to inform machine 105 of FIG. 1 about the event. Event framework 435 of FIG. 4 may use AEN if there was no program associated with the event in event table 440 of FIG. 4 (in which case storage device 120 of FIG. 1 may be unable to perform self-maintenance), or if there was a program associated with the event in event table 440 of FIG. 4 but the program was not able to successfully perform remediation (in which case machine 105 of FIG. 1 may need to handle remediation for the event). Note that event framework 435 of FIG. 4 may also use AEN to notify machine 105 of FIG. 1 of the event even if remediation was possible and successful. But in some embodiments of the disclosure, in some situations, event framework 435 of FIG. 4 might not notify machine 105 of FIG. 1 of the event, and block 955 of FIG. 9 may be omitted, as shown by dashed line 960.

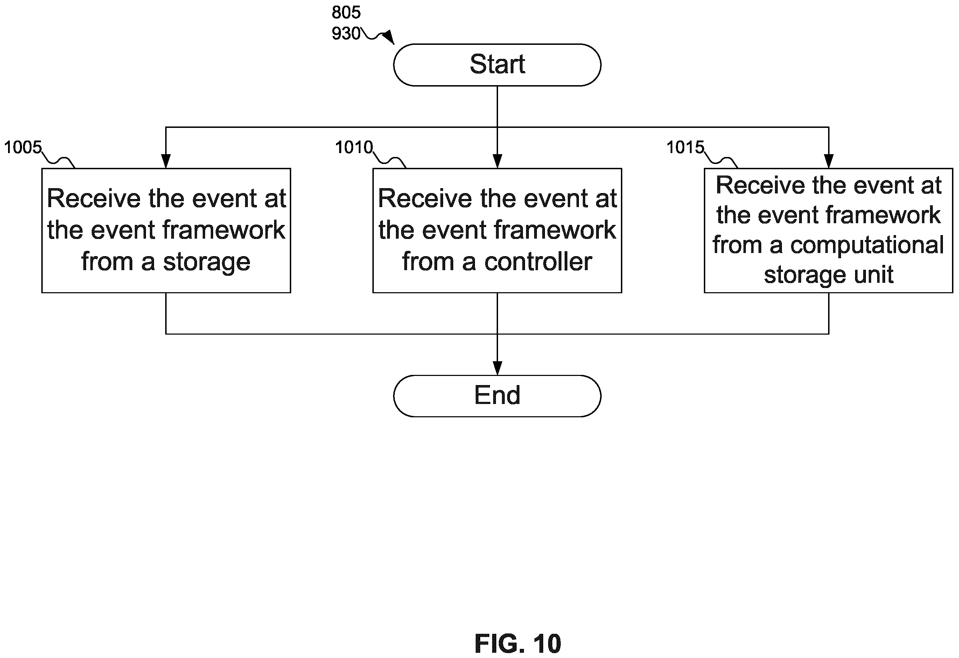

FIG. 10 shows a flowchart of an example procedure for event framework 435 of FIG. 4 to receive an event, according to embodiments of the disclosure. In FIG. 10, at block 1005, event framework 435 of FIG. 4 may receive notice of an event from storage 425 of FIG. 4. Alternatively, at block 1010, event framework 435 of FIG. 4 may receive notice of an event from storage controller 415 of FIG. 4. Alternatively, at block 1015, event framework 435 of FIG. 4 may receive notice of an event from computational storage unit 135 of FIG. 1. It does not matter what the source of the notification is: event framework 435 of FIG. 4 may proceed to handle the event similarly.

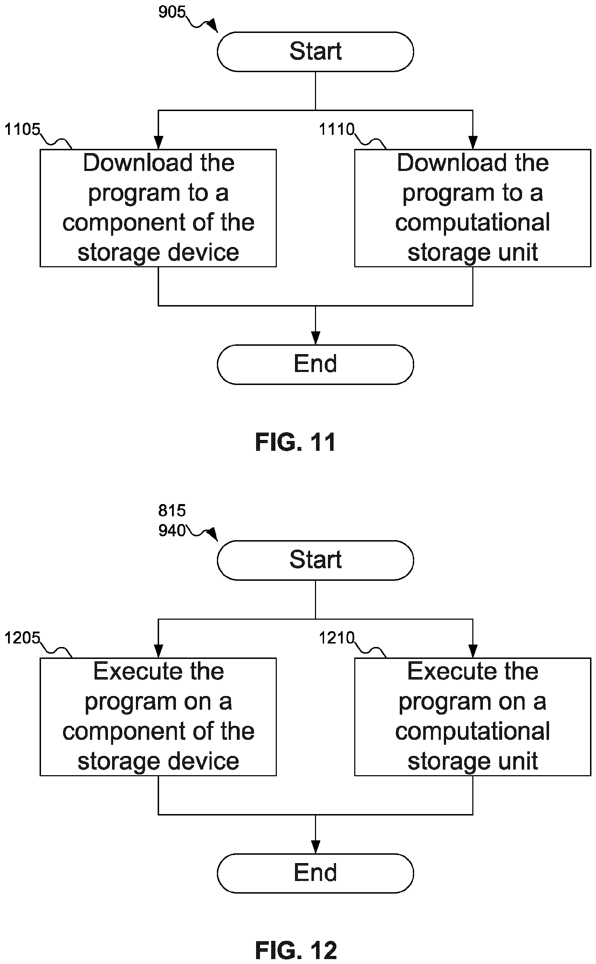

FIG. 11 shows a flowchart of an example procedure for machine 105 of FIG. 1 to download a maintenance program, according to embodiments of the disclosure. In FIG. 11, at block 1105, machine 105 of FIG. 1 may download a program to a component of storage device 120 of FIG. 1 that is capable of executing the program. Note that this component might not be a computational storage unit built into storage device 120 of FIG. 1: for example, this component might be a processor used by storage device 120 for other processing, but that has sufficient resources (computational power and/or processing cycles) to be able to execute the program. Alternatively, at block 1110, machine 105 of FIG. 1 may download the program to computational storage unit 135 of FIG. 1, which may be paired with storage device 120 of FIG. 1.

FIG. 12 shows a flowchart of an example procedure for event framework 435 of FIG. 4 to execute a maintenance program, according to embodiments of the disclosure. In FIG. 12, at block 1205, event framework 435 of FIG. 4 causes a program to be executed using a component of storage device 120 of FIG. 1 that is capable of executing the program. Again, this component might not be a computational storage unit built into storage device 120 of FIG. 1: for example, this component might be a processor used by storage device 120 for other processing, but that has sufficient resources (computational power and/or processing cycles) to be able to execute the program. Alternatively, at block 1210, event framework 435 of FIG. 4 may cause the program to be executed on to computational storage unit 135 of FIG. 1, which may be paired with storage device 120 of FIG. 1.

In FIGs. 8-12, some embodiments of the disclosure are shown. But a person skilled in the art will recognize that other embodiments of the disclosure are also possible, by changing the order of the blocks, by omitting blocks, or by including links not shown in the drawings. All such variations of the flowcharts are considered to be embodiments of the disclosure, whether expressly described or not.

Embodiments of the disclosure enable a storage device to perform self-maintenance and/or self-remediation. By using a program executed on a computational storage unit associated with the storage device, the storage device may perform maintenance or remediation in response to events without relying on the host processor. This reduces the load on the host processor, freeing the host processor to perform other tasks. As the host processor may be responsible for managing any number of storage devices, reducing the load on the host processor may be a significant benefit.

The storage device may store pairs of event IDs and associated program IDs. These pairs may be registered by the host processor, which also downloads the programs to be executed if the events occur.

If the storage device is unable to completely address an event that occurs, the storage device may refer the event to the host processor for handling.

Embodiments of the disclosure may include a computational storage unit 135 of FIG. 1 which may be a flexible, programmable storage platform that developers may use to create a variety of scalable accelerators that solve a broad range of data center problems.

As disclosed in some embodiments of the disclosure, Non-Volatile Memory Express (NVMe) technology has built-in capabilities to help understand, predict and prevent Solid State Drive (SSD) failures.

Embodiments of the disclosure may include a framework that may utilize the benefits of this Computational Storage architecture to automate management, monitoring, and tuning processes for NVMe SSDs.

In some embodiments of the disclosure, the framework may be defined as follows. First, a host may download a diagnostic program to a computational storage unit 135 of FIG. 1. Second, the diagnostic program may then be associated with various events that occur in the device 120 of FIG. 1. Third, the program may be executed as these events occur in the device 120. Fourth and finally, the program may perform error recovery (self-healing).

An NVMe device may have built-in capabilities to monitor the status and health of SSDs. These capabilities, in various embodiments of the disclosure, may include features such as logging to log all events occurring in the system as well as event and error reporting, including Asynchronous Events, Operation failures, and Rebuild Assistance, among other capabilities. These capabilities, in some embodiments of the disclosure, may help understand where and why things are failing and report when it does happen.

In some embodiments of the disclosure, the log page 630 of FIG. 6 may be used to describe extended error information for a command that completed with error or report an error that is not specific to a particular command. Additionally, asynchronous events may be used to notify host software of status, error, and health information as these events occur.

Furthermore, in some embodiments of the disclosure, the SSD events may be grouped into the following event types: Error events; Health Status events; Notice events; NVM Command Set Specific events; and Vendor Specific events.

NVMe computational storage involves, in some embodiments of the disclosure, offloading execution of a program from a host to a controller. The computational storage unit 135 of FIG. 1 may allow, in some embodiments of the disclosure, for programs to be loaded, discovered, configured, and executed by the host.

There may be two categories of programs: downloadable programs which may be loaded and executed on the NVMe controller by the host; and device-defined programs which may be provided by the NVMe controller.

Additionally, controllers of the various embodiments herein may support a subset of one or more program types: for example, Extended Berkeley Packet Filter (eBPF) Executable and Linkable Format (ELF), Program Type, Field Programmable Gate Array (FPGA) Bitstream, and Operating System image type, to name a few. The controller may also work in bare metal mode, where the program type may be specific for that ISA and custom built. All these program types built may additionally be protected by a signature key for security, authenticity and corruptions. In such embodiments of the disclosure, the controller may employ a mechanism to verify the program before any execution.

Embodiments of the disclosure may provide for automated error detection and resolution, and may include vendor programs that understand the data. Furthermore, embodiments of the disclosure may also provide protection from Data loss/corruption. If an event occurs for which reporting is disabled/or there are no Asynchronous Event Request commands outstanding, the host might lose critical data. The proposed solution automates error recovery and thus minimizing data loss, also known as high availability. Additionally, embodiments of the disclosure provide for scalability. In an enterprise server with 50 SSDs, for example, the host may spend most of its CPU resources managing/monitoring the SSDs. Some embodiments of the disclosure may run device management/error recovery within the device or the computational storage unit 135 of FIG. 1 and hence free up host CPU resources.

Embodiments of the disclosure may: enable high availability, as automatic recovery from failures may reduce application downtime; reduce the cost of ownership by automating routine tasks; maximize SSD performance, as the diagnostic programs may help predict and prevent SSD errors; and offer a scalable solution, as host CPU resources are freed up.

In embodiments of this disclosure, the programs may be either diagnostic programs or reactive programs. Diagnostic programs may collect relevant information about an event. Reactive programs may include failover, deduplication, etc.

The programs may be executed once, or may run as many times as an event is posted (also known as a persistent program). For persistent execution programs, the program execution may be disabled by issuing a set features command again (in-line with disabling AEN). In some embodiments of the disclosure, a program may be associated with multiple events. Additionally, the programs may clear the events after appropriate event handling is performed (without host intervention).

Embodiments of the disclosure may handle events arising from computational storage unit 135 of FIG. 1 and storage device 120 of FIG. 1. That is, the event framework may trigger program execution due to events arising from the computational storage unit as well as the storage device.

In some embodiments of the disclosure, multiple programs may run in parallel in the computational storage unit 135 of FIG. 1. The programs may invoke other programs in the device to complete the error recovery (e.g., running a device self-test). Additionally, if the device 120 of FIG. 1 supports interactions with other devices, the programs may interact with other devices in the transport for error recovery (*e*.*g*., failover data from another SSD or scale data to another SSD when spare threshold is hit).

The programs may maintain state across various runs and may alter execution flow based on the states. For example, a failover program might recover failed Logical Block Addresses (LBAs) on every LBA status information alert. The program might also keep track of the number of failures the device 120 of FIG. 1 has reported (failure threshold). The program may then skip the failover action if the failure threshold reaches certain limit, instead taking the device offline for host operations.

Additionally, embodiments of the disclosure may include connecting an FPGA to an SSD via an NVMe connection. Further embodiments of the disclosure may include performing deduplication operations associated with storage by the FPGA.

The following discussion is intended to provide a brief, general description of a suitable machine or machines in which certain aspects of the disclosure may be implemented. The machine or machines may be controlled, at least in part, by input from conventional input devices, such as keyboards, mice, etc., as well as by directives received from another machine, interaction with a virtual reality (VR) environment, biometric feedback, or other input signal. As used herein, the term "machine" is intended to broadly encompass a single machine, a virtual machine, or a system of communicatively coupled machines, virtual machines, or devices operating together. Exemplary machines include computing devices such as personal computers, workstations, servers, portable computers, handheld devices, telephones, tablets, etc., as well as transportation devices, such as private or public transportation, e.g., automobiles, trains, cabs, etc.

The machine or machines may include embedded controllers, such as programmable or non-programmable logic devices or arrays, Application Specific Integrated Circuits (ASICs), embedded computers, smart cards, and the like. The machine or machines may utilize one or more connections to one or more remote machines, such as through a network interface, modem, or other communicative coupling. Machines may be interconnected by way of a physical and/or logical network, such as an intranet, the Internet, local area networks, wide area networks, etc. One skilled in the art will appreciate that network communication may utilize various wired and/or wireless short range or long range carriers and protocols, including radio frequency (RF), satellite, microwave, Institute of Electrical and Electronics Engineers (IEEE) 802.11, Bluetooth^{®}, optical, infrared, cable, laser, etc.

Embodiments of the present disclosure may be described by reference to or in conjunction with associated data including functions, procedures, data structures, application programs, etc. which when accessed by a machine results in the machine performing tasks or defining abstract data types or low-level hardware contexts. Associated data may be stored in, for example, the volatile and/or non-volatile memory, e.g., RAM, ROM, etc., or in other storage devices and their associated storage media, including hard-drives, floppy-disks, optical storage, tapes, flash memory, memory sticks, digital video disks, biological storage, etc. Associated data may be delivered over transmission environments, including the physical and/or logical network, in the form of packets, serial data, parallel data, propagated signals, etc., and may be used in a compressed or encrypted format. Associated data may be used in a distributed environment, and stored locally and/or remotely for machine access.

Embodiments of the disclosure may include a tangible, non-transitory machine-readable medium comprising instructions executable by one or more processors, the instructions comprising instructions to perform the elements of the disclosures as described herein.

The various operations of methods described above may be performed by any suitable means capable of performing the operations, such as various hardware and/or software component(s), circuits, and/or module(s). The software may comprise an ordered listing of executable instructions for implementing logical functions, and may be embodied in any "processor-readable medium" for use by or in connection with an instruction execution system, apparatus, or device, such as a single or multiple-core processor or processor-containing system.

The blocks or steps of a method or algorithm and functions described in connection with the embodiments disclosed herein may be embodied directly in hardware, in a software module executed by a processor, or in a combination of the two. If implemented in software, the functions may be stored on or transmitted over as one or more instructions or code on a tangible, non-transitory computer-readable medium. A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art.

Having described and illustrated the principles of the disclosure with reference to illustrated embodiments, it will be recognized that the illustrated embodiments may be modified in arrangement and detail without departing from such principles, and may be combined in any desired manner. And, although the foregoing discussion has focused on particular embodiments, other configurations are contemplated. In particular, even though expressions such as "according to an embodiment of the disclosure" or the like are used herein, these phrases are meant to generally reference embodiment possibilities, and are not intended to limit the disclosure to particular embodiment configurations. As used herein, these terms may reference the same or different embodiments that are combinable into other embodiments.

The foregoing illustrative embodiments are not to be construed as limiting the disclosure thereof. Although a few embodiments have been described, those skilled in the art will readily appreciate that many modifications are possible to those embodiments without materially departing from the novel teachings and advantages of the present disclosure.

## Claims

1. A storage device (120), comprising:
first storage (320) for storing a data;
a controller (315) to manage access to the data in the first storage (320);
a second storage to store a first identifier (505) and a second identifier (510), the first identifier (505) for an event and the second identifier (510) for a program; and
a processor (330) to receive the event and execute the program based at least in part on the second storage, wherein the processor (330) is configured to execute the program on a computational storage unit (310) based at least in part on the second storage, wherein the computational storage unit (310) is connected to a host (105), the host (105) storing the program, and wherein the computational storage unit (310) is configured to receive the program from the host (105) as a download based at least in part on the processor (330) receiving the event.

2. The storage device (120) according to claim 1, wherein the storage device (120) is configured to receive an association between the first identifier (505) and the second identifier (510) from a host (105).

3. The storage device (120) according to claim 2, wherein the storage device (120) is further configured to store the first identifier (505) and the second identifier (510) in the second storage.

4. The storage device (120) according to any one of claims 1 to 3, wherein the processor (330) is configured to trigger an asynchronous event notification to a host (105) by the processor (330) based at least in part on the event.

5. The storage device (120) according to any one of claims 1 to 4, wherein the program includes state information for the storage device (120).

6. The storage device (120) according to claim 5, wherein the program is configured to execute the program based at least in part on an occurrence of the event and the state information.

7. A method, comprising:
receiving an event at a processor (330) of a storage device (120);
identifying a program by the processor (330) based at least in part on an second storage and the event, the second storage associating a first identifier (505) and a second identifier (510), the first identifier (505) for the event and the second identifier (510) for the program;
executing the program on a computational storage unit (135) based at least in part on the second storage; and
downloading the program from the host (105) based at least in part on receiving the event at the processor (330) of the storage device (120).

8. The method according to claim 7, further comprising receiving an association between the first identifier (505) and the second identifier (510).

9. The method according to claim 8, wherein receiving an association between the first identifier (505) and the second identifier (510) includes storing the first identifier (505) and the second identifier (510) in the second storage.

10. The method according to any one of claims 7 to 9, further comprising triggering an asynchronous event notification to a host (105) by the processor (330) based at least in part on the event.

11. The method according to any one of claims 7 to 10, wherein executing the program includes executing the program based at least in part on an occurrence of the event and a state information for the storage device (120).

12. An article, comprising a non-transitory storage medium, the non-transitory storage medium having stored thereon instructions that, when executed by a machine, result in:
performing the method according to any one of claims 7 to 11.

## Patentansprüche

1. Speichervorrichtung (120), aufweisend:
einen ersten Speicher (320) zum Speichern von einem Datum;
einen Controller (315) zum Verwalten eines Zugriffs auf das Datum in dem ersten Speicher (320);
einen zweiten Speicher zum Speichern eines ersten Identifikators (505) und eines zweiten Identifikators (510), des ersten Identifikators (505) für ein Ereignis und des zweiten Identifikators (510) für ein Programm; und
einen Prozessor (330) zum Empfangen des Ereignisses und zum Ausführen des Programms basierend zumindest teilweise auf dem zweiten Speicher, wobei der Prozessor (330) so konfiguriert ist, dass das Programm auf einer Rechen-Speichereinheit (310) basierend zumindest teilweise auf dem zweiten Speicher ausgeführt wird, wobei die Rechen-Speichereinheit (310) mit einem Host (105) verbunden ist, wobei der Host (105) das Programm speichert, und wobei die Rechen-Speichereinheit (310) so konfiguriert ist, dass das Programm von dem Host (105) als ein Download basierend zumindest teilweise auf dem Prozessor (330), welcher das Ereignis empfängt, empfangen wird.

2. Speichervorrichtung (120) nach Anspruch 1, wobei die Speichervorrichtung (120) so konfiguriert ist, dass sie eine Zuordnung zwischen dem ersten Identifikator (505) und dem zweiten Identifikator (510) von einem Host (105) empfängt.

3. Speichervorrichtung (120) nach Anspruch 2, wobei die Speichervorrichtung (120) ferner so konfiguriert ist, dass sie den ersten Identifikator (505) und den zweiten Identifikator (510) in dem zweiten Speicher speichert.

4. Speichervorrichtung (120) nach einem der Ansprüche 1 bis 3, wobei der Prozessor (330) so konfiguriert ist, dass er eine asynchrone Ereignismitteilung an einen Host (105) durch den Prozessor (330) basierend zumindest teilweise auf dem Ereignis auslöst.

5. Speichervorrichtung (120) nach einem der Ansprüche 1 bis 4, wobei das Programm eine Zustandsinformation für die Speichervorrichtung (120) beinhaltet.

6. Speichervorrichtung (120) nach Anspruch 5, wobei das Programm so konfiguriert ist, dass das Programm basierend zumindest teilweise auf einem Zustandekommen des Ereignisses und der Zustandsinformation ausgeführt wird.

7. Verfahren, folgende Schritte aufweisend:
Empfangen eines Ereignisses an einem Prozessor (330) von einer Speichervorrichtung (120);
Identifizieren eines Programms durch den Prozessor (330) basierend zumindest teilweise auf einem zweiten Speicher und dem Ereignis, wobei der zweite Speicher einen ersten Identifikator (505) und einen zweiten Identifikator (510) zuordnet, den ersten Identifikator (505) für das Ereignis und den zweiten Identifikator für das Programm;
Ausführen des Programms auf einer Rechen-Speichereinheit (135) basierend zumindest teilweise auf dem zweiten Speicher; und
Downloaden des Programms von dem Host (105) basierend zumindest teilweise auf dem Empfangen des Ereignisses an dem Prozessor (330) der Speichervorrichtung (120).

8. Verfahren nach Anspruch 7, ferner aufweisend ein Empfangen einer Zuordnung zwischen dem ersten Identifikator (505) und dem zweiten Identifikator (510).

9. Verfahren nach Anspruch 8, wobei das Empfangen einer Zuordnung zwischen dem ersten Identifikator (505) und dem zweiten Identifikator (510) ein Speichern des ersten Identifikators (505) und des zweiten Identifikators (510) in dem zweiten Speicher beinhaltet.

10. Verfahren nach einem der Ansprüche 7 bis 9, ferner aufweisend ein Auslösen einer asynchronen Ereignismitteilung an einen Host (105) durch den Prozessor (330) basierend zumindest teilweise auf dem Ereignis.

11. Verfahren nach einem der Ansprüche 7 bis 10, wobei das Ausführen des Programms ein Ausführen des Programms basierend zumindest teilweise auf einem Zustandekommen des Ereignisses und einer Zustandsinformation für die Speichervorrichtung (120) beinhaltet.

12. Artikel, aufweisend ein nichttransitorisches Speichermedium, wobei das nichttransitorische Speichermedium auf ihm gespeicherte Anweisungen aufweist, welche, wenn sie durch eine Maschine ausgeführt werden, folgenden Schritt zur Folge haben:
Durchführen des Verfahrens nach einem der Ansprüche 7 bis 11.

## Revendications

1. Dispositif de stockage (120), comprenant :
un premier stockage (320) pour stocker des données ;
un dispositif de commande (315) pour gérer un accès aux données dans le premier stockage (320) ;
un second stockage pour stocker un premier identifiant (505) et un second identifiant (510), le premier identifiant (505) étant pour un événement et le second identifiant (510) étant pour un programme ; et
un processeur (330) pour recevoir l'événement et exécuter le programme sur la base au moins en partie du second stockage, dans lequel le processeur (330) est configuré pour exécuter le programme sur une unité de stockage de calcul (310) sur la base au moins en partie du second stockage, dans lequel l'unité de stockage de calcul (310) est reliée à un hôte (105), l'hôte (105) stockant le programme, et dans lequel l'unité de stockage de calcul (310) est configurée pour recevoir le programme depuis l'hôte (105) en tant qu'un téléchargement sur la base au moins en partie de la réception de l'événement par le processeur (330).

2. Dispositif de stockage (120) selon la revendication 1, dans lequel le dispositif de stockage (120) est configuré pour recevoir une association entre le premier identifiant (505) et le second identifiant (510) depuis un hôte (105).

3. Dispositif de stockage (120) selon la revendication 2, dans lequel le dispositif de stockage (120) est en outre configuré pour stocker le premier identifiant (505) et le second identifiant (510) dans le second stockage.

4. Dispositif de stockage (120) selon l'une quelconque des revendications 1 à 3, dans lequel le processeur (330) est configuré pour déclencher une notification d'événement asynchrone à un hôte (105) par le processeur (330) sur la base au moins en partie de l'événement.

5. Dispositif de stockage (120) selon l'une quelconque des revendications 1 à 4, dans lequel le programme inclut des informations d'état pour le dispositif de stockage (120) .

6. Dispositif de stockage (120) selon la revendication 5, dans lequel le programme est configuré pour exécuter le programme sur la base au moins en partie d'une occurrence de l'événement et des informations d'état.

7. Procédé, comprenant :
la réception d'un événement au niveau d'un processeur (330) d'un dispositif de stockage (120) ;
l'identification d'un programme par le processeur (330) sur la base au moins en partie d'un second stockage et de l'événement, le second stockage associant un premier identifiant (505) et un second identifiant (510), le premier identifiant (505) étant pour l'événement et le second identifiant (510) étant pour le programme ;
l'exécution du programme sur une unité de stockage de calcul (135) sur la base au moins en partie du second stockage ; et
le téléchargement du programme depuis l'hôte (105) sur la base au moins en partie de la réception de l'événement au niveau du processeur (330) du dispositif de stockage (120) .

8. Procédé selon la revendication 7, comprenant en outre la réception d'une association entre le premier identifiant (505) et le second identifiant (510).

9. Procédé selon la revendication 8, dans lequel la réception d'une association entre le premier identifiant (505) et le second identifiant (510) inclut le stockage du premier identifiant (505) et du second identifiant (510) dans le second stockage.

10. Procédé selon l'une quelconque des revendications 7 à 9, comprenant en outre le déclenchement d'une notification d'événement asynchrone à un hôte (105) par le processeur (330) sur la base au moins en partie de l'événement.

11. Procédé selon l'une quelconque des revendications 7 à 10, dans lequel l'exécution du programme inclut l'exécution du programme sur la base au moins en partie d'une occurrence de l'événement et d'informations d'état pour le dispositif de stockage (120).

12. Article, comprenant un support de stockage non transitoire sur lequel sont stockées des instructions qui, lorsqu'elles sont exécutées par une machine, engendrent :
la réalisation du procédé selon l'une quelconque des revendications 7 à 11.
